# EUROPEAN PATENT APPLICATION

(11) **EP 4 793 951 A1**
(43) Date of publication of application: **19.08.2026**
(21) Application number: 26157697.9
(22) Date of filing: 10.02.2026
(51) Int. Cl.: G11C 11/44

(54) **SUPERCONDUCTING NON-VOLATILE MEMORY CELL, METHOD OF WRITING, AND METHOD OF READING THEREOF**

(30) Priority: 12.02.2025 PL 45120725
(71) Applicant: Instytut Fizyki Polskiej Akademii Nauk, 02-668 Warszawa (PL)
(72) Inventor: Zgirski, Maciej, 01-684 Warszawa (PL); Foltyn, Marek, 02-170 Warszawa (PL)
(74) Representative: Bury & Bury

(57) **Abstract**

A non-volatile superconducting memory cell containing type-II superconductors, adapted to operate at a temperature (**T₀**) below the critical temperature (**Tc**) of the superconductors and under a magnetic field (**B**) with a magnetic induction exceeding the critical value (**B₀**) for the type-II superconductor and consisting of a serial connection of the first superconducting line (**103**), the superconducting trap (**101**), the Dayem bridge (**102**), and the second superconducting line (**106**), according to the invention, is characterized in that the dimensions (**Wt, Lt**) of the superconducting trap (**101**) and the dimensions (**Wb**, **Lb**) of the Dayem bridge (**102**) and the magnetic field induction value (**B**) are selected such that the superconducting vortex expulsion current (**I_{OUT}**) is lower than the first critical current (**I_{C1}**) and the first critical current ( **I_{C1}**) is lower than the second critical current (**I_{C2}**).

The object of the invention is also a method of writing and a method of reading.

## Description

### Technical field

The invention concerns a superconducting non-volatile memory cell, a method of writing and a method of reading information encoded by trapping a single superconducting vortex in a trap.

### DESCRIPTION OF THE STATE OF THE ART

Systems using a single vortex in a superconductor as a memory cell are known in the art.

In the publication: Nat. Commun. 6:8628 (2015), "Single Abrikosov vortices as quantized information bits*,"* two systems are disclosed to demonstrate the reading and writing of information using a single superconducting vortex trapped in a trap. The first system demonstrated is composed of two superconducting niobium layers separated by a spin valve. A small hole was made in the niobium layer with an ion gun in order to better stabilize the vortex in the process of writing logical information. After the initial calibration consisting in measuring the magnetic resistance of the Nb-valve-Nb structure, the working point of the memory cell (set temperature and a specific value of the external magnetic field) was selected and then a series of logical information writing and reading operations was demonstrated, sending alternately positive and negative current pulses, at the same time writing the resistance of the structure, which changed permanently depending on the polarization of the current pulse sent: it reached the maximum value after a positive pulse (logical value "1") and the minimum value after a negative pulse (logical value "0"). In the second demonstrated system consisting of two longitudinal superconductor-metal - superconductor junctions, between which there is a superconducting vortex trap, the procedure for calibration and writing and reading logical information is very similar to that of the first system, with the difference that logical operations can also be performed in the absence of an external magnetic field. In subsequent publications, the same authors (Nat. Commun. 13, 3658 (2022): "Demonstration of a superconducting diode-with-memory, operational at zero magnetic field with switchable nonreciprocity*",* Nat. Commun. 14, 4926 (2023): "Word and bit line operation of a 1 × 1 µm2 superconducting vortex-based memory") informed about the development of a similar concept of writing logical information using a single vortex in a superconductor, optimizing the logical operation procedure.

In Communications Physics 7, 88 (2024), "Demonstration of a Josephson vortex-based memory cell with microwave energy-efficient readout*",* a system is disclosed in which the reading and writing of information was demonstrated using a single superconducting vortex trapped in a superconductor-metal -superconductor (Nb-Cu-Nb) junction. This junction is integrated into the microwave resonator. By examining the resonance modes (frequencies corresponding to the maximum absorption of microwave energy in the S₂₁ transmission mode) as a function of the external magnetic field, it is possible to determine the conditions for subsequent superconducting vortices to enter the junction - the resonance frequency strongly depends on the presence or absence of a vortex in the junction. In the first step, the magnetic field was determined slightly below the threshold of entry of the first vortex into the junction and then the current flowing through the coil was modified in steps. Increasing the magnetic field caused the vortex to enter the junction, while significantly reducing the field of its escape. Thanks to magnetic hysteresis, the demonstrated effect of writing information was stable.

Patent application number PL443801A1 discloses a system and method for detecting superconducting vortices, the number of which in the superconducting trap can be controlled by an external magnetic field. Vortex detection is performed by measuring the switching current of the Dayem bridge, which is directly connected to the superconducting trap. The described method consists in sending a sequence of current pulses to the Dayem bridge, in a fixed external magnetic field, with an amplitude corresponding to the specified probability of switching the bridge from the superconducting state to the normal state. The change in the number of superconducting vortices in the trap is recorded as a step change in the switching current of the Dayem bridge. The disadvantage of the solution according to PL443801A1 is that it does not allow multiple writings to be made in a simple, convenient, fast and scalable way. There is no information in PL443801A1 on how to remove the once introduced vortex and at the same time provide a reading without the risk of causing change in the state.

There are also other systems using single one-dimensional vortices (so-called *phase slips),* which are not stationary superconducting current vortices in nanostructures (e.g. in RSFQ technology - *Rapid Single Flux Quantum*). Systems using superconducting vortex groups in a superconductor (*arrays* or *lattices*) as bit information are also known. The main disadvantage of these systems is the inability to miniaturize them - in both technologies, memory cells range in size from a few to several micrometers.

### Technical problem to be solved

An object of the invention is to solve a problem of enabling multiple write and read in a superconducting non-volatile memory cell in a simple, convenient, fast and scalable manner.

### Summary of the invention

The invention concerns a superconducting non-volatile memory cell comprising type-II superconductors, configured to operate at a temperature below the critical temperature of the superconductors and in the magnetic field larger than its critical value for the type-II superconductors. The non-volatile memory superconducting cell comprises series connection of a first superconducting line, a superconducting trap made of a type-II superconductor characterized by a vortex expulsion current Iₒᵤₜ, a Dayem bridge made of a type-II superconductor distinguished by a first critical current **I_{C1},** the flow of which brings the superconducting trap with the trapped superconducting vortex into a normal state above the critical temperature **Tc,** and a second critical current **I_{C2},** which brings the superconducting trap without the trapped superconducting vortex into a normal state above the critical temperature **Tc,** and a second superconducting line. The dimensions of the superconducting trap and the dimensions of the Dayem bridge and the magnetic field induction value are selected such that value of the expulsion current Iₒᵤₜ is lower than the first critical current **I_{C1}** and the first critical current **I_{C1}** is less than the second critical current **I_{C2}.** Under such conditions, current pulses can be easily selected to enable writing of individual states and reading. In the normal state there is no superconductivity.

Advantageously, the superconducting trap and the Dayem bridge are made of polycrystalline aluminum evaporated onto a silicon wafer.

The method of writing in a non-volatile memory superconducting cell according to the invention comprises a step of determining the operating conditions in which the cell is placed in an environment with a temperature **T₀** below the critical temperature **Tc** of the superconductors and a magnetic field with a magnetic induction **B₀** value exceeding the critical value for the type-II superconductors is applied, and a step of writing the information. At the step of writing information for writing the first state, a current pulse is applied with a current value exceeding the second critical current I_{C2} of the Dayem bridge and a duration greater than or equal to 10 ps. To write the second state, a current pulse is used with a current exceeding the expulsion current I**ₒᵤₜ**, but lower than the first critical current **I_{C1}** of the Dayem bridge and a duration greater than or equal to 10 ps. The time of 10 ps is sufficient both to heat the Dayem bridge with a current exceeding its critical value so as to switch the superconducting trap to the normal state, and to expel the superconducting vortex out of the trap with a lower current pulse.

The method of reading according to the invention from a superconducting non-volatile memory cell according to the invention comprises a step of determining the operating conditions consisting of placing the cell in an ambient temperature below the critical temperature **Tc** of the superconductors and applying a magnetic field with a magnetic induction exceeding the critical value for the second type of superconductors used, and a step of reading the information. In the reading step, a reading current is provided having a value between the first critical current **I_{C1}** and the second critical current **I_{C2},** and the status is read by measuring the voltage **(U)** between the first and second superconducting lines.

Advantageously, the reading current is given in the form of a pulse consisting of a testing part (for which the amplitude of the current has a reading current value) and a sustain part that keeps the trap in a normal state when the Dayem bridge is switched over by the testing part.

### Advantageous effects of the invention

The inventions allow the writing, permanent storage and reading of logical information in a superconducting memory cell by controlling the presence of a single superconducting vortex in the superconducting trap using a specific value of the amplitude of the current pulse - within three given intervals, corresponding to the operation of logical writing "0", logical writing "1" and reading the logical state of the cell. It is a convenient, fast and scalable solution. Access times are at the level of tens of picoseconds. The read operation does not change the logical state of the cell. The cell memory remains non-volatile as long as the ambient temperature **T₀** is less than the critical temperature of the **Tc** superconductor and the superconductor is placed in a constant magnetic field of the order of several mT.

### Short description of figures

The invention will be further explained in the embodiments discussed with reference to the figures of the drawing.

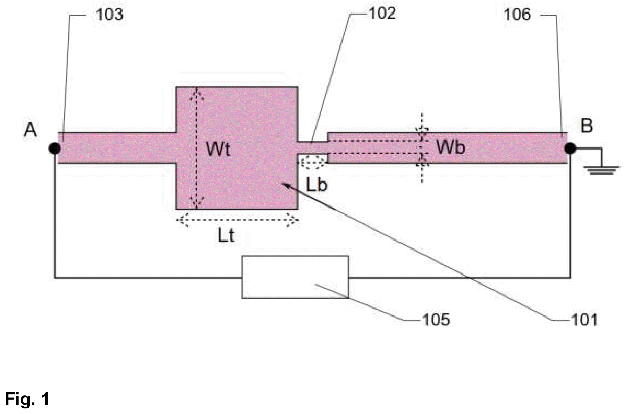

Fig. 1 schematically illustrates an elementary superconducting memory cell according to an embodiment of the invention, in a test setup,

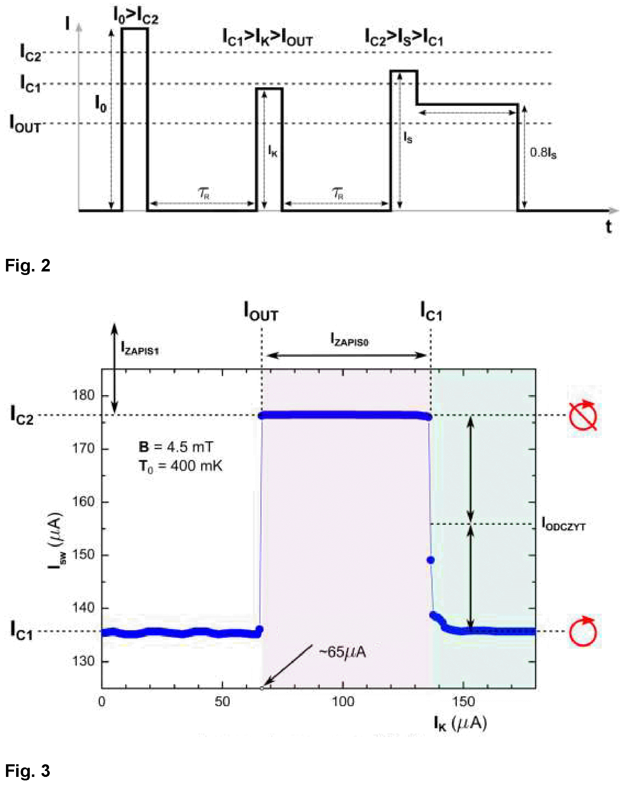

Fig. 2 shows the sequence of three current pulses used to determine the calibration curve. Shown in Fig. 2 values were selected so that the first pulse saves the state "1", the second saves the state "0", and the third creates conditions enabling the state to be read.
Fig. 3 shows a calibration curve determined experimentally using the pulse sequence shown in FIG. 2. The calibration curve represents the dependence of the switching current *I_{SW}* of the detector on the I_{K} amplitude of the control pulse, at a constant ambient temperature **T₀** = 400 mK and in a constant magnetic field perpendicular to the trap surface with a value of **B** = 4.5 mT. The calibration curve allows to determine the values of **I_{C1}, I_{C2}**, **I**_{**ou**t}.

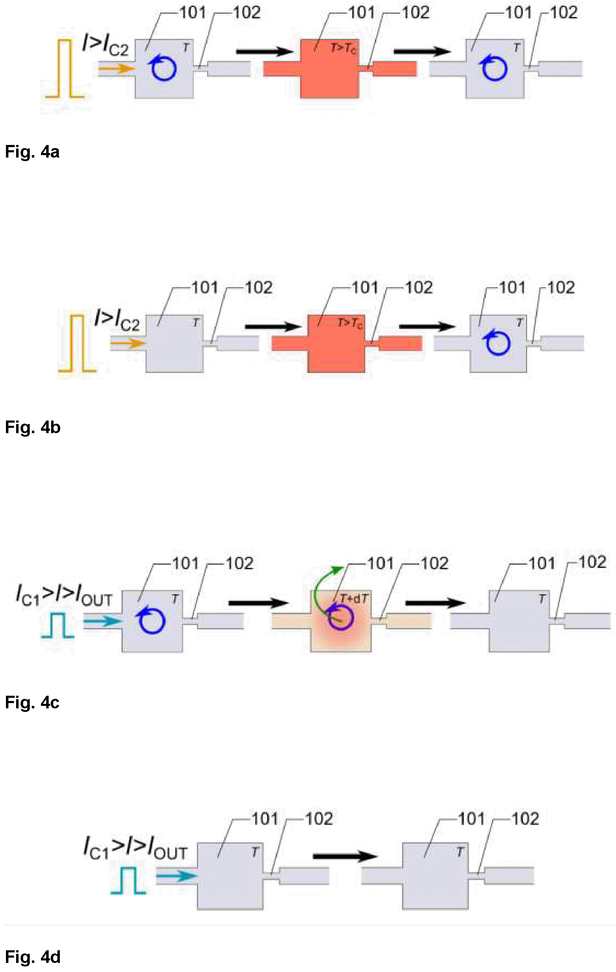

Fig. 4a-d show the writing scheme. Fig. 4a shows the consequences of exposing a cell with the vortex, i.e. being in the "1" state, to a current pulse with a current intensity value exceeding the second critical value I > I_{C2}. Fig. 4b shows the consequences of exposing a cell without a vortex, i.e. being in the "0" state, to a current pulse with a current intensity value exceeding the second critical value I >**I_{C2}.** Fig. 4c shows the consequences of exposing the cell with vortex, i.e. being in the "1" state, to a current pulse with a current intensity value between the value of superconducting vortex expulsion current and the first critical value: **I_{C1} > I** > **Iₒᵤₜ**. Fig. 4d shows the consequences of exposing a cell without a vortex, i.e. being in the "0" state, to a current pulse with a current intensity value between the expulsion current value and the first critical value **I_{C1} > I > Iₒᵤₜ.**

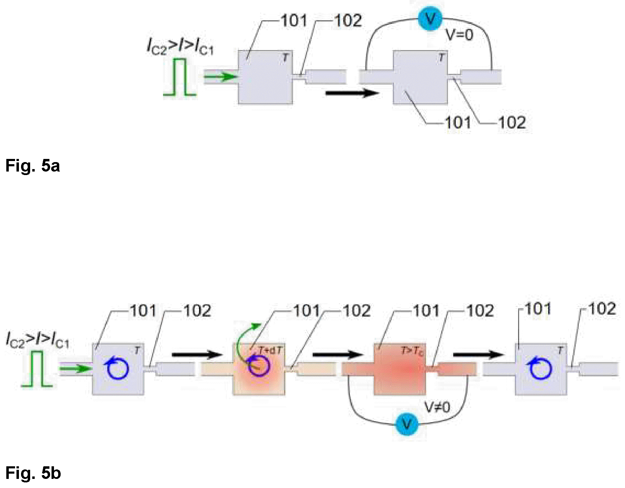

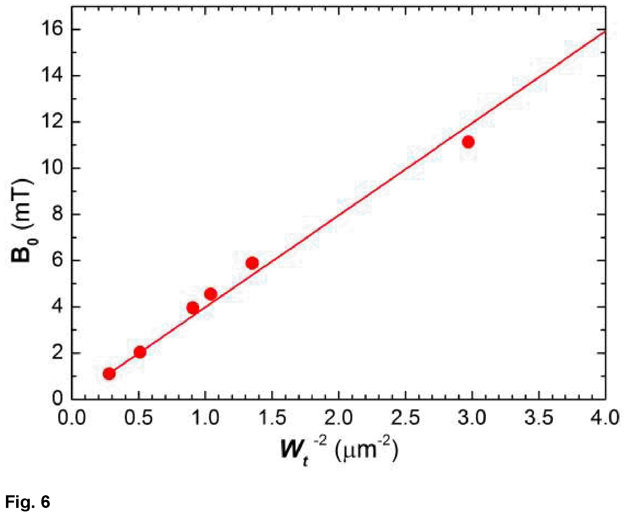

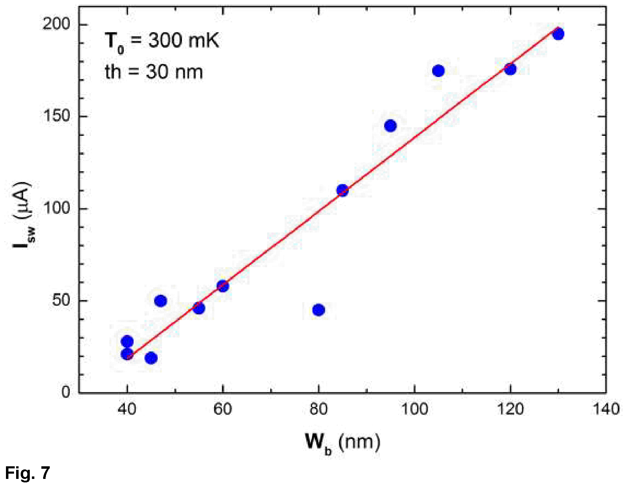

Fig. 5a and b illustrate a memory reading. Fig. 5a shows a diagram of the operation of reading the logical state of an elementary memory cell in a situation where this state is "0". Fig. 5b shows a diagram of the operation of reading the logical state of an elementary memory cell in a situation where this state is "1". Fig. 6 shows the dependence of the critical magnetic field induction value **B₀** on the inverse of the area of the square superconducting traps, made of polycrystalline aluminum with a thickness of 30 nm. The points correspond to the values of the actual surfaces of the superconducting magnetic vortex traps, and the straight line is a numerical match. Fig. 7 shows the dependence of the value of the second critical current I_{C2} of the Dayem bridge as a function of its width under zero magnetic field conditions.

### Description of embodiments

Fig. 1 schematically illustrates an elementary, superconducting non-volatile memory cell according to an embodiment of the invention in a test system. The cell can assume one of two states, hence is binary. Exemplary methods of reading and writing logical information are based on a nomenclature in which the presence of a vortex in the superconducting trap **101** means "1" and the absence of a vortex means "0".

The elemental memory cell is made by evaporating polycrystalline aluminum onto a monocrystalline silicon wafer by electron beam lithography. Shown in Fig. 1 cell comprises a superconducting trap **101** made of square aluminum with a side **Wt** = **Lt** = 1 µm and a thickness of 30 nm. This cell is integrated with the detector in the form of a Dayem bridge **102** having a width of **Wb** = 130 nm, a thickness of 30 nm and a length of **Lt** = 210 nm. The Dayem bridge **102** is attached to the center of the side of the trap **101.** A first superconducting line **103** is attached to the opposite side of the trap **101** and a second superconducting line **106** is attached to the Dayem bridge. Both superconducting lines have a width of 360 nm, a thickness (height) of 30 nm and a length of 15 µm.

The cell was cooled in a Triton 400 dilution refrigerator from Oxford Instruments to a temperature of 400 mK, i.e. below the critical temperature **Tc** for aluminum, which for these elements is about 1.3° K.

The values of the external magnetic fields **B₀** and **B₁,** in which the first and second magnetic vortices penetrate the superconducting trap, were determined experimentally. At a fixed ambient temperature **T,** where **T**≤**T_{C}** and **T_{C}** is the critical temperature of the superconductor used, and at a fixed value of the external magnetic field chosen from the range **B₀, B₁** perpendicular to the superconducting surface of the trap, the calibration **I_{sw}(Iₖ)** is performed. Calibration was performed by applying to the Dayem bridge **102** sequence of **N** current pulses with a period τ ranging from 10 ns to 1 µs, wherein the first pulse of each sequence is an initializing pulse with a duration of 10 ps to 100 µs and an amplitude **I₀** higher than the amplitude of the second critical current **I_{c2},** the second pulse of each sequence is a control pulse with a duration of 5 ps to 100 µs and an amplitude **I_{K},** while the third pulse of each sequence is a testing pulse having a probing part with a duration of 10 ps to 5 µs and an amplitude I_{S}, and a readout sustain part with an amplitude of less than 0.9 A and a duration of 10 ns to 10 µs. Then there is the value of the amplitude of the current **I_{S}** = I_{SW} corresponding to the set number of pulse counts **n = P·N** on the counter **105,** where **P** is any fixed number from the range (0,1). The procedure is repeated for all set values of the amplitude **I_{K}** of the control pulse and the **I_{SW}(I_{K})** calibration curve is prepared from the recorded counts. The calibration curve allows to determine the values of **I_{C1},** I_{C2}**, Iₒᵤₜ.** Then, from this curve, the value of the amplitude of the pulse reading the logical state of the memory cell from the interval **(I_{C1}, I_{C2})** is determined, and most preferable value **I_{ODCZYT} = (I_{C1}+ I_{C2}**)/2, and the value of the amplitude of the pulse writing the logical state "0" in the memory cell from the interval (Iₒᵤₜ, **I_{C1}),** and most preferably for the value I_{ZAPIS0} = **(I_{C1}** + **Iₒᵤₜ**)/2, as well as the value of the amplitude **I_{ZAPIS1}** of the pulse writing the logical state "1" in the memory cell, taking the value of the amplitude greater than **I_{C2}.**

It should be emphasized that the calibration curve results in a wide range and freedom of choice of various adequate current values **I_{IZAPIS1}, I_{IZAPIS0}, IODCZYT.**

It is important that the writing current of the state "1", **I_{ZAPIS1}** is higher than the value of the second critical current **I_{C2}.** Since the value of the second critical current is higher than the value of the first critical current **I_{C1},** which switches the superconducting trap **101** to the normal state under conditions without trapped vortex, applying current of the value of **I_{ZAPIS1},** regardless of the state of the superconducting memory cell, will cause the cell to temporarily transition to the normal state as a result of raising the cell temperature above the critical temperature **Tc** and introducing a superconducting vortex (exactly one vortex), since the induction value of the magnetic field applied to the memory cell is between **B₀** and **B₁ (I_{C2}, I_{C1}, Iₒᵤₜ, B₀, B₁** were defined above).

It is important that the current value of the writing state "0", **I_{ZAPIS0}** for both the initial state "0" and "1" is lower than the critical current **I_{C1},** but higher than the expulsion current I_{OUT}. Under such conditions, the application of the pulse causes the superconducting vortex to be expelled from the trap **101** without losing superconductivity and switching the memory cell to the normal state, and thus without creating conditions for the vortex to re-form thereafter. Since the value of the first critical current **I_{C1}** is lower than the value of **I_{C2}** the second critical current, the condition for writing "0" is **I_{OUT}** < **I_{ZAPIS0}< I_{C1}.**

The value of the reading current I_{ODCZYT} is between the values of the first critical current **I_{C1}** and the second critical current **I_{C2}.** This arrangement of values causes that in conditions where there is no vortex in the superconducting trap **101,** the superconducting memory cell does not switch to the normal state and there is no measurable voltage drop - see Fig. 5a. If there is a vortex in the trap, the memory cell switches to the normal state and a voltage drop is noted, which can be sustained by extending the current pulse with the readout sustain part. At the end of the pulse, the memory cell returns to the superconducting state **101,** being in a magnetic field of induction **B** > **B₀,** intercepting the vortex. After reading, the cell is in a state with a trapped superconducting vortex. As a result, the reading does not disturb the state of the cell and, more precisely, does not change it in the case of state "0" without the trapped superconducting vortex and restores it to its initial state after the reading in the case of state "1" - with the trapped superconducting vortex.

The logical information "1" is written by sending a single current pulse with an amplitude value of I_{ZAPIS1} to the detector and the logical information "0" is written in the elementary memory cell by sending a single current pulse with an amplitude value of I_{ZAPIS0} to the detector.

The logical information is read from the elementary memory cell by first sending to the detector a single current pulse with the amplitude value I_{ODCZYT}, after which a single voltage pulse count for the logical state "1" of the elementary memory cell or no count for the logical state "0" in this cell is read from the counter **105.**

The method of the invention makes it possible to read and write logical information in a superconducting memory cell by creating and annihilating an individual superconducting vortex in a superconducting trap integrated into the Dayem bridge detector **102.** The corresponding logical operation (write/read) is carried out by sending a single current pulse of a fixed amplitude.

During writing and reading to the one shown in Fig. 1 point A, the output of the arbitrary waveform generator Agilent 33620A was connected, from which, each time after sending the pulse, the voltage drop on the Dayem bridge **102** was measured using a voltage pulse counter **105** in the form of a Lecroy WaveRunner HRO 66Zi oscilloscope.

In exemplary implementations of the writing method and the reading method, both the writing and the reading were carried out at a fixed ambient temperature of **T₀** = 400 mK. Experimentally, the magnetic field values of the first and second superconducting vortex entry to the superconducting trap were determined, which are **B₀** = 4.4 mT and **B₁** = 8.2 mT, respectively. Then, a constant external magnetic field was applied, perpendicular to the surface of the trap, with a value of **B** = 4.5 mT, guaranteeing the possibility of trapping a single superconducting vortex. This enables the operation of a binary elementary superconducting non-volatile memory cell.

Writing the logical information "1" consists in sending a single current pulse with an amplitude **I_{ZAPIS1},** which, regardless of the initial state of the trap, overheats the superconducting part of the elementary memory cell to the normal state and then, during its cooling, captures a single vortex, the presence of which in the trap is identical to the logical state "1".

Writing the logical information "0" consists in sending a single current pulse with an amplitude of **I_{ZAPIS0},** which, in the case of the presence of a vortex in the trap, expels it from the trap without overheating it above **Tc,** and in case of the absence of a vortex in the trap, does not change its state. In both cases, the logical state of the elementary memory cell after sending the pulse with amplitude **I_{K}** is "0".

The values of currents were determined in the calibration process. The detector in the form of a Dayem bridge was treated with a sequence of **N** = 1,000 sequences of three current pulses: an initializing pulse with a value of the maximum current intensity **I₀,** a control pulse and a testing pulse shown in Fig. 2, sent from the arbitrary waveform generator Agilent 33620A, connected to point A with a period τ = 200 µs, and the amplitude of the initialization pulse **I₀** = 180 µA with a duration of 5 ns, and the amplitude of the control pulse **I_{K}** = 0 and a duration of 5 ns, and the amplitude of the probing part of the testing pulse **I_{S}** = 135.3 µA, with a duration of 5 ns, and the readout sustain part of the testing pulse with an amplitude of 0.8 I_{S} = 108.2 µAand a duration of 5 µs. The amplitude of the probing part **I_{S}** was determined so that the number of counts on the counter **105** (Lecroy WaveRunner HRO 66Zi oscilloscope), for each sequence of 1,000 sequences, was 500 with an accuracy of up to 5%. The T_{R} interval between the pulses should be no less than the thermal relaxation time of the system and has been set at a multiple of the relaxation time T_{R} = 40 µs.

The above procedure was repeated for successive values of amplitudes of the control pulse **I_{K},** increasing from 1 µA to 180 µA every 1 µA, obtaining the calibration curve shown in Fig. 3. This is the dependence of the switching current of the Dayem bridge **I_{SW} on** the amplitude of the control pulse I_{K}, for the number of counts of **n** = 500, with an accuracy of 5%. The step change of the switching current I_{SW} for the control pulse **I_{K}** = 65 µA corresponds to the threshold for expulsion a single vortex out of the superconducting trap.

Then, from the calibration curve **I_{SW}(I_{K}),** there were read amplitude values for the three pulses **I_{ODCZYT}, I_{ZAPIS0}, I_{ZAPIS1},** which allow the logical information to be read and written in the elementary memory cell by sending a single current pulse. Each of the three pulses was assigned the following amplitude values: **I_{ZAPIS0}** = 100 µA, I_{ZAPIS1} = 160 µA I_{ODCZYT} = 156 µA. These pulses can be assigned any amplitude value within the interval marked on the calibration curve, i.e. for the pulse: **I_{ZAPIS0}** from 65 µA to 136 µA, for the pulse I_{ZAPIS1} greater than 176 µA, for the pulse **I_{ODCZYT}** from 136 µA to 176 µA.

If the elemental cell is in the state "1", i.e. that there is a superconducting vortex in the trap, sending a single current pulse I_{ODCZYT} will expel the vortex and overheat the trap above **Tc** and thus the voltage pulse will appear on the counter. If the elemental cell is in the state "0", that is, there is no superconducting vortex in the trap, sending a single current pulse I_{ODCZYT} will not change the trap state and there will be no voltage pulse on the counter because the trap will remain in the superconducting state.

The scheme of writing to memory is illustrated in Fig. 4a-d. The blue wrapped arrow indicates the presence of a vortex in the trap. Red indicates that the trap is overheating above the critical temperature **(Tc).**

The method of writing the logical value "1" in the system of the elementary memory cell, regardless of the initial state of the trap (trap with or without a vortex), consists in sending a single current pulse with an amplitude of **I_{ZAPIS1}.** The logical value "1" corresponds to the presence of a superconducting vortex in the trap as shown in Fig. 4a, if there was a superconducting vortex before the writing operation, then the pulse of amplitude I_{ZAPIS1} overheats the system above the critical temperature **Tc,** the vortex disappears, and after the end of the pulse **I_{ZAPIS1},** the system cools down in a constant magnetic field, capturing a single vortex and leaving the elementary memory cell in the state "1". If, as shown in Fig. 4b, at the beginning there was no vortex in the trap, then the pulse of amplitude I_{ZAPIS1} overheats the system above the critical temperature **T_{C},** and after the end of the pulse **I_{ZAPIS1},** the system cools down in a constant magnetic field, capturing a single vortex and leaving the elemental memory cell in the state "1".

The method of saving the logical value "0" in an elementary memory cell, regardless of the initial state of the trap, consists in sending a single current pulse with an amplitude of **I_{ZAPIS0}.** The logical value "0" corresponds to the absence of a superconducting vortex in the trap.

As shown in Fig. 4c, if before the writing operation there was a superconducting vortex in the trap, then the pulse of amplitude **I_{ZAPIS0}** expels a single vortex without overheating the system above the critical temperature **T_{C},** and leaves the elementary memory cell without the vortex, i.e. in the state "0". If, however, as shown in Fig. 4d, before the writing operation, there was no superconducting vortex in the trap, then the pulse of amplitude **I_{ZAPIS0}** does not change the state of the system, leaving the elementary memory cell in the state "0". This operation is possible due to the fact that the dimensions of the memory cell and the Dayem bridge have been selected so that the superconducting vortex expulsion current **(I_{OUT})** is lower than the first critical current **(I_{C1})** and the first critical current **(I_{C1})** is lower than the second critical current **(I_{C2}).**

The method of reading the logical value stored in the elementary memory cell system consists in sending a single current pulse with an amplitude I_{ODCZYT} and recording the counts on the counter **105.** Reading the state of the elementary memory cell does not destroy the stored information as shown in Fig. 5a, if before the reading operation the elementary memory cell was in the state "1" (the vortex is in the trap), sending the pulse **I_{ODCZYT}** will expel the vortex and overheat the trap above **T_{C},** and then cool it in a constant magnetic field and capture a single vortex into the trap. The overheating of the elementary memory cell above **T_{C}** is recorded by the counter in the form of a single voltage pulse (single count). Therefore, the process of reading the state "1" does not change the physical state of the memory cell. If, however, as shown in Fig. 5b, prior to the reading operation, the elementary memory cell was in state "0" (no vortex in the trap) sending the pulse I_{ODCZYT} will not cause any change, so no voltage pulse will be recorded on the counter.

The operation of exemplary implementations of the method of writing and reading was verified by performing **N** = 1000 one-time operations consisting in writing the logical value "1" in an elementary memory cell and directly reading its state and the value of **n** = 1000 was read on the counter. **N** = 1000 one-time operations were also performed, consisting in writing the logical value "0" in an elementary memory cell and directly reading its state, and the value of **n** = 0 was read on the counter. The above result is proof of the absence of errors in the tested method of writing and reading (means 100% fidelity of the writing and reading process).

The value of the magnetic field, at which the first vortex enters the trap, for an example of a thin square-shaped aluminum trap, can be read directly from the relationship shown in Fig. 6, i.e. the experimental dependence of the critical field **B₀** on the inverse of the surface of the square-shaped trap with the side **Wt.** This allows you to skip the step of calibrating the entry of the vortex into the trap. The error in determining the above-mentioned value is approx. 5 % When using traps of a shape other than a square or made of another material, a one-time calibration should be carried out again, e.g. according to the method described in application P.443801. The calibration carried out in the example allows to determine the minimum current of a single superconducting vortex expulsion out of the trap and is universal. For the fixed geometry of the superconducting trap, the specified temperature and the constant magnetic field, we will obtain the same value of the minimum amplitude of the pulse I_{ZAPIS0} expelling the vortex out of the trap. This means that if a large number of traps of the same nominal shape (in actual processes they will be slightly different) are made on one chip, each of them will have a very similar range of currents I_{ZAPIS0}**.**

It is also possible to predict the switching current of the detector in the form of a Dayem bridge based on its geometry. For example, for a series of aluminum Dayem bridges with a width **Wb** ranging from 40 nm to 130 nm, with a constant thickness of 30 nm and a length L_{b} of approx. 200 nm, the value of the bridge switching current at a temperature of 300 mK approximately meets the equation I_{SW} = (2 µA/nm)***Wb** - 60 µA, for the width of the Dayem bridge **Wb** given in nanometers - as shown in Fig. 7. This relationship was determined experimentally. Using modern devices for fabrication of nanostructures (e.g. e-beam writer), it is possible to obtain high repeatability of the dimensions of Dayem bridges and thus to predict their switching current Isw quite precisely.

The speed of writing and reading the logical information is limited by the thermal relaxation time τ_{R} of the elementary memory cell caused by overheating of the superconducting part to the normal state or the expulsion of the superconducting vortex from the trap. The τ_{R} time can be shortened by increasing the operating temperature of the superconductor, which results in a more effective heat outflow from the system by increasing the so-called electron-phonon interactions, i.e. the efficiency of transferring heat from overheated electrons to cooler atoms of the crystal lattice.

The superconducting vortex is more difficult to be expelled from the trap if the external magnetic field is high. For this reason, after determining the values of the fields of entry for the first **(B₀)** and second **(B₁)** vortex into the trap, it is recommended to set an external magnetic field slightly greater than **B₀.** In higher magnetic fields, the execution of logical operations will involve the use of correspondingly higher values of pulse currents controlling the operation of superconducting memory.

The proposed method allows for integrated matrices composed of a large number of elementary memory cells on one chip, without the need to calibrate each individual element. The effect of the trap memory is permanent while maintaining the system temperature significantly lower than the critical temperature of the superconductor used and the constant value of the external perpendicular magnetic field, and once the superconducting vortex is expelled from the trap, it cannot return to it. For mass production of this type of superconducting memory, only a one-time calibration would be required for the fixed geometry of magnetic vortex traps and Dayem bridge detectors, and the amplitude values of the three key pulses for logical operations **(I_{ODCZYT}, I_{ZAPIS0},** I_{ZAPIS1} can be selected from a relatively wide range of values - see Fig. 3.

Execution of an elementary superconducting memory cell system from other superconducting materials with a smaller coherence length ξ (e.g. Nb, NbTi) allows to reduce the size of the trap, due to the smaller diameter of the superconducting vortex. In addition, the use of superconductors with high critical temperature (e.g. Nb, NbTi, NbN, etc.) allows to avoid the use of advanced sorption or dilution coolers.

### Industrial applicability of the invention

The memory cell according to the invention and the method of reading and writing logical information according to the invention use current pulse effects on a single quantum superconducting vortex, in an elementary superconducting memory cell system, having a superconducting trap integrated into the detector in the form of a Dayem bridge. The proposed structure and method allows for permanent storage and reading of logical information by controlling the presence of a single superconducting vortex in the superconducting trap using a specific current pulse amplitude value - within three set intervals.

## Claims

1. A superconducting non-volatile memory cell comprising type-II superconductors,
configured to operate at a temperature (T₀) below a critical temperature of the superconductors and under a magnetic field **(B)** having a magnetic induction exceeding a critical value for the type-II of superconductors
and
comprising series connection of
a first superconducting line **(103),**
a superconducting trap **(101)** made of the type-II superconductor and having a superconducting vortex expulsion current (I_{OUT}),
a Dayem bridge **(102),** made of the type-II superconductor and having
a first critical current **(I_{C1}),** sufficient to switch the trap to a normal state **(101)** with a trapped superconducting vortex and
a second critical current **(I_{C2})** sufficient to switch the trap without a trapped superconducting vortex to a normal state **(101),**
and a second superconducting line **(106),**
**characterized in that**
the dimensions **(Wt, Lt)** of the superconducting trap **(101)** and the dimensions **(Wb, Lb)** of the Dayem bridge **(102)** and the magnetic field induction value **(B)** are selected such that the superconducting vortex expulsion current **(I_{OUT})** is lower than the first critical current **(I_{C1})** and the first critical current **(I_{C1})** is lower than the second critical current **(I_{C2}).**

2. The superconducting non-volatile memory cell according to claim 1, wherein the superconducting trap **(101)** and the Dayem bridge **(102)** are made of polycrystalline aluminum evaporated onto a silicon wafer.

3. A method of writing to a superconducting non-volatile memory cell as defined in any one of claims 1 or 2, comprising
a step of establishing operating conditions in which this cell is placed in an environment with a temperature **(T₀)** lower than the critical temperature of the superconductors and a magnetic field having a magnetic induction value **(B)** exceeding the critical value for the type-II superconductors **(B₀)** is applied, and
a step of writing information
**characterized in that** in the step of writing information
for writing a first state, there is applied a current pulse having current value (I_{ZAPIS1}) exceeding the second critical current **(I_{C2})** of the Dayem bridge **(102)** and having a duration greater than or equal to 10 ps, while
for writing a second state, there is applied a current pulse having a current value **(I_{ZAPIS0})** exceeding the superconducting vortex expulsion current **(I_{OUT})** but lower than the first critical current **(I_{C1})** of the Dayem bridge **(102)** and having a duration greater than or equal to 10 ps.

4. A method of reading from a superconducting non-volatile memory cell as defined in any one of claims 1 or 2, comprising
a step of establishing operating conditions in which the cell is placed in an environment with a temperature below the critical temperature of the superconductors and a magnetic field **(B)** having a magnetic induction exceeding the critical value **(B₀)** for the type-II superconductors, and
a step of reading information
**characterized in that**
in the step of reading state information
there is applied a read current **(I_{ODCZYT})** having a value between the first critical current **(I_{C1}** ) and the second critical current **(I_{C2}),** and the state is read by measuring the voltage **(U)** between the first superconducting line **(103)** and the second superconducting line **(106).**

5. The method of reading according to claim 4, wherein that the current is given in a form of the pulse comprising a readout sustain part, in which a value of current is lower than the first critical current (I_{C1}) and greater than the superconducting vortex expulsion current **(I_{OUT}).**
